Europäisches Patentamt

European Patent Office

Office européen des brevets

(19)

(11) Veröffentlichungsnummer: **0 429 858 A2**

(12) **EUROPÄISCHE PATENTANMELDUNG**

(21) Anmeldenummer: 90120520.3

(22) Anmeldetag: 26.10.90

(51) Int. Cl.5: **H03L 7/183**

(30) Priorität: 28.11.89 DE 3939260

(43) Veröffentlichungstag der Anmeldung:
05.06.91 Patentblatt 91/23

(84) Benannte Vertragsstaaten:
**DE ES FR GB IT Patentblatt**

(71) Anmelder: **Rohde & Schwarz GmbH & Co. KG**
**Mühldorfstrasse 15**
**W-8000 München 80(DE)**

(72) Erfinder: **Bögl, Thomas, Dipl.-Ing.**
**Nördlinger Strasse 65**
**W-8901 Königsbrunn(DE)**

(74) Vertreter: **Graf, Walter, Dipl.-Ing.**
**Sckellstrasse 1**
**W-8000 München 80(DE)**

(54) **Normalfrequenzgenerator.**

(57) Bei einem Frequenzgenerator mit einem phasengeregelten Oszillator wird die Referenzfrequenz in einem Synthesizer in direkter digitaler Synthese erzeugt; dabei wird die Ausgangsfrequenz dieses DS-Synthesizers mittels eines Mischers hochgemischt und mittels eines Frequenzteilers wieder auf einen solchen Referenzfrequenzwert heruntergemischt, so daß die in der Phasenregelschleife des Oszillators erzeugte Nebenwellenvergrößerung durch diese beim Herunterteilen der Ausgangsfrequenz des Synthesizers erzeugte Nebenwellenverringerung kompensiert ist.

EP 0 429 858 A2

# NORMALFREQUENZGENERATOR

Die Erfindung geht aus von einem Normalfrequenzgenerator laut Oberbegriff des Hauptanspruches.

Die Referenzfrequenz von phasengeregelten Oszillatoren (PLL-Synthesizer) muß neben einem hohen Rauschabstand auch eine große Nebenwellenfreiheit besitzen, da der Störhub solcher Nebenwellen mit dem Teilungsfaktor der Phasenregelschleife vervielfacht und als störende Nebenlinien im Ausgangsspektrum des Oszillators erscheinen würde. Hier sind insbesondere die Nebenlinien wichtig, die innerhalb oder nur wenig außerhalb der Regelschleifenbandbreite liegen, da diese von der normal als schmalbandiges Filter wirkenden Phasenregelschleife nicht mehr weggefiltert werden können. Aus diesem Grunde werden als Referenzfrequenzquelle bei üblichen Frequenzgeneratoren dieser Art, deren Ausgangsfrequenz möglichst nebenwellenfrei sein soll, stets hochwertige Quarzfrequenzoszillatoren oder davon abgeleitete Synthesizer benutzt.

Es sind an sich auch Synthesizer bekannt, die nach dem Prinzip der direkten digitalen Synthese arbeiten (DDS-Synthesizer, beispielsweise nach "Neues von Rohde & Schwarz, Heft 123, 1988, S. 16, US-PS 3 735 269 bzw. DE 27 36 133), die es ermöglichen, mit Quarzfrequenzgenauigkeit beliebige Frequenzen in beliebig feinen Schritten zu erzeugen, die jedoch den Nachteil geringer Nebenwellenfreiheit von beispielsweise nur 60 bis 70 dB nahe dem Träger besitzen. Aus diesem Grunde sind solche DDS-Synthesizer nicht als Referenzfrequenzquellen für Normalfrequenzgeneratoren mit den obengenannten Forderungen nach Nebenwellenfreiheit geeignet.

Es ist Aufgabe der Erfindung, einen Normalfrequenzgenerator mit einem phasengeregelten Oszillator zu schaffen, der trotz beliebig feiner Einstellung seiner Ausgangsfrequenz die geforderte hohe Nebenwellenfreiheit besitzt.

Diese Aufgabe wird ausgehend von einem Normalfrequenzgenerator laut Oberbegriff des Hauptanspruches durch dessen kennzeichnende Merkmale gelöst. Vorteilhafte Weiterbildungen ergeben sich aus den Unteransprüchen.

Gemäß der Erfindung wird als Referenzfrequenzquelle ein bekannter DDS-Synthesizer benutzt, wobei dessen bekannte schlechte Nebenwellenfreiheit durch den zusätzlichen Frequenzteilungsvorgang auf einen Wert herabgesetzt wird, der ausreicht, um die anschließend in der Regelschleife erzeugte Nebenwellenverschlechterung wieder zu kompensieren. Damit ist es erstmals möglich, als Referenzfrequenzquelle für einen PLL-Synthesizer einen DDS-Synthesizer zu benutzen, der es ermöglicht, die Referenzfrequenz in beliebig kleinen Frequenzschritten und damit auch die Ausgangsfrequenz des PLL-Synthesizers in entsprechend feinen Schritten einzustellen, ohne daß die Fanggeschwindigkeit der Regelschleife negativ beeinflußt wird, da die Frequenz, bei welcher der Phasenvergleich erfolgt, sehr hoch gelegt werden kann. Der durch die erfindungsgemäße Maßnahme an sich erreichte geringe Störhub der Referenzfrequenz wird durch den Teilungsfaktor der Phasenregelschleife zwar wieder verschlechtert, je nach Bemessung der Frequenzvervielfachung und anschließenden Frequenzteilung kann jedoch erreicht werden, daß das abschließend am Ausgang des Oszillators erzeugte Nebenwellenspektrum unter dem Rauschspektrum des phasengeregelten Oszillators liegt. Im allgemeinen genügt es, die Vervielfachung und anschließende Teilung der durch den DDS-Synthesizer erzeugten Referenzfrequenz so zu wählen, daß am Ausgang des phasengeregelten Oszillators wieder das ursprüngliche Nebenwellenspektrum des DDS-Synthesizers auftritt, hier also ein Nebenwellenabstand von 60 bis 70 dB ausreicht. Diese Nebenwellen werden bei großen Schleifenbandbreiten unter dem Rauschspektrum des Oszillators verdeckt, bei schmalen Schleifenbandbreiten können sie dagegen problemlos weiter unterdrückt werden.

Die erfindungsgemäße Maßnahme ist für alle phasengeregelten Oszillatoren geeignet, auch solche, die keinen Frequenzteiler in der Regelschleife aufweisen, in diesem Fall wird durch die Nebenwellenverbesserung der Referenzfrequenz insgesamt die Nebenwellenfreiheit der Ausgangsfrequenz verbessert. Die Änderung der Nebenwellenfreiheit durch die erfindungsgemäße Maßnahme ist abhängig von dem Verhältnis $M/N$, wobei $M$ der feste Teilungsfaktor ist, mit dem die Referenzfrequenz heruntergeteilt wird und $N$ der Teilungsfaktor in der Phasenregelschleife ist. Daraus ist ersichtlich, daß die Nebenwellenfreiheit der Ausgangsfrequenz des Oszillators um so besser ist, je größer $M$ gewählt wird. In der Praxis hängt die Dimensionierung der Frequenzvervielfachung und Frequenzteilung von den Anforderungen ab, die bezüglich Nebenwellen an das Gesamtsystem gestellt werden, wobei auch die Schleifenbandbreite des Systems zu berücksichtigen ist. Im allgemeinen wird es genügen, den Teilungsfaktor $M$ nur so groß zu wählen, daß das Nebenwellenspektrum auch nach Verschlechterung in der Phasenregelschleife unterhalb des Rauschspektrums des verwendeten Oszillators liegt, wenn $M = N$ gewählt ist, ist das Nebenwellenspektrum am Ausgang genauso groß wie am Ausgang des DDS-Synthesizers. Der Vervielfachungsfaktor für das Hochmischen der Referenzfrequenz muß nicht gleich dem anschließenden Frequenzteilungsfaktor sein, diese beiden Faktoren können je nach gegebener Ausgangsfrequenz des DDS-Synthesizers und der gewünchten Referenzfrequenz für die Phasenregelschleife auch unterschiedlich groß sein, auf diese Weise kann jede beliebige Vergrößerung oder Verringerung der der Phasenregelschleife zugeführten Referenzfrequenz erreicht werden.

Die Erfindung wird im folgenden anhand einer schematischen Zeichnung an einem Ausführungsbeispiel näher erläutert.

Die Fig. zeigt das Prinzipschaltbild eines Normalfrequenzgenerators zum Erzeugen einer Ausgangsfrequenz $f_a$, wie sie beispielsweise zur Ansteuerung eines Hochfrequenz-Nachrichtensenders benutzt wird. Er besteht aus einem phasengeregelten Oszillator 1 mit einem spannungsgesteuerten Oszillator 2, der in einer Phasenregelschleife mit einem Phasenvergleichsglied 3 und einem auf beliebige Teilungsfaktoren einstellbaren Frequenzteiler 4 und einem zwischen Phasenvergleichsglied 3 und Oszillator 2 angeordneten Filter 5 in bekannte Weise angeordnet ist. Dem Phasenvergleichsglied 3 wird eine Referenzfrequenz $f_r$ zugeführt, die in einem nach der direkten digitalen Synthese arbeitenden Synthesizer 6 in ebenfalls an sich bekannter Weise erzeugt wird. Dieser Synthesizer 6 besteht beispielsweise aus einem Addierer 11, dem aus einem Taktgenerator 7 eine feste quarzgenaue Taktfrequenz zugeführt wird. Aus einem Inkrementregister 12 werden diesem Addierer 11 vorbestimmte Zahleninkremente zugeführt, die an einer Einstellvorrichtung 13 entsprechend der gewünschten Ausgangsfrequenz einstellbar sind. Der Addierer 11 addiert im Takt der Taktfrequenz die vom Inkrementregister 12 zugeführten Zahleninkremente, auf die in einem Speicher (Latch) 16 zwischengespeicherte letzte Summe. Mit dieser schrittweise erhöhten Summe des Addierers 11 wird ein Speicher 14 (EPROM) adressiert, in welchem die Stützwerte einer vollen Sinusperiode gespeichert sind. Der Addierer 11 liest also Schritt für Schritt eine Sinusperiode aus dem Speicher 14 aus, die dann über einen Digital/Analog-Wandler 15 in eine analoge Sinusspannung der Frequenz $f_R$ umgesetzt wird. Die Frequenz der Sinusspannung wird also durch die Größe des eingegebenen Zahleninkrements bestimmt, bei einem kleinen Inkrement wird eine niedrige, bei einem großen Inkrement eine entsprechend höhere Frequenz erzeugt. Die unmittelbare digitale Synthese eines Sinussignals kann in dem Synthesizer 6 auch auf andere bekannte Weise, beispielsweise unmittelbar durch einen Rechner erzeugt werden.

Die Ausgangsfrequenz $f_R$ dieses DDS-Synthesizers 6 wird durch einen Mischer 8 auf eine höhere Zwischenfrequenz $f_z$ hochgemischt und nach dem Durchlaufen eines Filters 9 mittels eines Frequenzteilers 10 mit dem Teilungsfaktor M auf die gewünschte Referenzfrequenz $f_r$, die der Phasenregelschleife 3 zugeführt wird, heruntergemischt. In einem praktischen Ausführungsbeispiel erzeugt der Synthesizer 6 eine in Schritten von beispielsweise 1 Hz mit Quarzfrequenzgenauigkeit einstellbare Ausgangsfrequenz $f_R$ zwischen 1 und 2 MHz. Durch Hochmischen mittels einer vom Quarz 7 durch Frequenzvervielfachung abgeleiteten Mischfrequenz von 100 MHz wird so eine Zwischenfrequenz von 101 bis 102 MHz erzeugt, die anschließend durch einen Frequenzteiler mit M = 101 auf eine Referenzfrequenz $f_R$ = 1 bis 1,01 MHz heruntergeteilt wird. Durch Wahl des Teilungsfaktors n des Frequenzteilers 4 in der Phasenregelschleife beispielsweise zwischen 100 und 400 kann so jede gewünschte Ausgangsfrequenz $f_a$ zwischen 100 und 400 MHz eingestellt werden, wobei über die am Synthesizer 6 feineinstellbare Referenzfrequenz $f_r$ beispielsweise in 1 Hz Schritten jeder Zwischenwert eingestellt werden kann. Die Einstellungen für den Teiler 4 und den Synthesizer 6 sind natürlich in einer Steuereinheit zusammengefaßt. Obwohl der Synthesizer 6 beispielsweise in seiner Ausgangsfrequenz $f_R$ einen Nebenwellenabstand von nur 60 dB besitzt, kann durch das Hochmischen und anschließende Heruntermischen der Nebenwellenabstand der dem Phasenvergleichsglied 3 zugeführten Referenzfrequenz $f_r$ um 30 bis 40 dB verbessert werden. Diese Nebenwellenverbesserung reicht aus, um eine durch den Teilungsfaktor N der Phasenregelschleife erzeugte Nebenwellenverschlechterung weitgehendst auszugleichen.

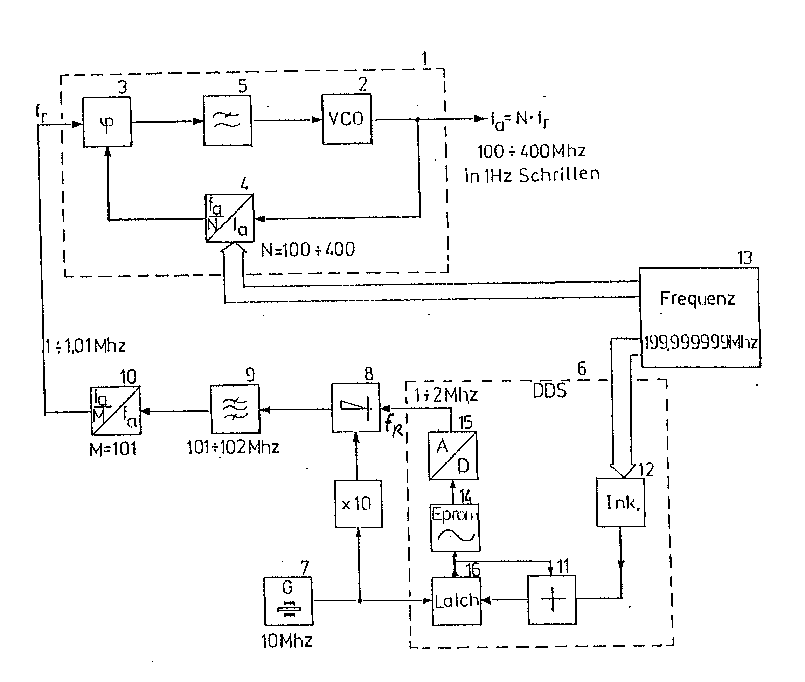

## Ansprüche

1.· Normalfrequenzgenerator, dessen Ausgangsfrequenz ($f_a$) mittels eines phasengeregelten Oszillators (1) erzeugt wird, dadurch **gekennzeichnet,** daß die Referenzfrequenz ($f_r$) für den Phasenvergleicher (3) des phasengeregelten Oszillators (1) in einem Synthesizer (6) in direkter digitaler Synthese erzeugt wird und die Ausgangsfrequenz ($f_R$) des Synthesizers (6) mittels eines Mischers (8) hochgemischt und mittels eines Frequenzteilers (10) wieder auf den gewünschten Referenzfrequenzwert ($f_r$) heruntergeteilt wird.

2. Normalfrequenzgenerator nach Anspruch 1 mit einem einstellbaren Frequenzteiler (4) in der Phasenregelschleife des phasengeregelten Oszillators (1), dadurch **gekennzeichnet,** daß das Teilungsverhältnis (M) des Frequenzteilers (10) zum Herunterteilen der Ausgangsfrequenz ($f_R$) des Synthesizers (6) etwa gleich dem maximal einstellbaren Teilungsfaktor (N) des Frequenzteilers (4) in der Phasenregelschleife gewählt ist.

$f_a = N \cdot f_r$

100 ÷ 400Mhz
in 1Hz Schritten

Frequenz 199,99999Mhz   13

1   2 VCO   5   3 φ

4 $\frac{f_a}{N}$ $f_a$   N=100÷400

Ink.   12

DDS   6

1÷2Mhz   15 A/D   14 Eprom   11 +   Latch   16

8 $f_R$   ×10   7 G 10Mhz

9   101÷102Mhz

10 $\frac{f_a}{M}$ $f_a$   M=101

1÷1,01Mhz

$f_r$